# EUROPÄISCHE PATENTSCHRIFT

(11) **EP 0 496 220 B1**
(45) Veröffentlichungstag und Bekanntmachung des Hinweises auf die Patenterteilung: **17.08.1994**
(21) Anmeldenummer: 92100323.2
(22) Anmeldetag: 10.01.1992
(51) Int. Cl.: C30B 31/04, C30B 29/22, C30B 31/00, C30B 29/20

(54) **Verfahren und Vorrichtung zur Herstellung von Kristallen sowie Kristall**
Process and apparatus for producing crystals or a crystal
Procédé et appareillage pour la production de cristaux ou un cristal

(30) Priorität: 25.01.1991 DE 4102136
(43) Veröffentlichungstag der Anmeldung: 29.07.1992
(73) Patentinhaber: Urland, Werner Prof.Dr.rer.nat., D-30989 Gehrden (DE); Tietz, Frank Dipl.-Chem., D-30171 Hannover (DE)
(72) Erfinder: Urland, Werner Prof.Dr.rer.nat., D-30989 Gehrden (DE); Tietz, Frank Dipl.-Chem., D-30171 Hannover (DE)
(74) Vertreter: Patentanwälte Thömen & Körner

(56) Entgegenhaltungen:
- EP-A- 0 132 321
- SOLID STATE IONICS, Bd. 39, 1990, AMSTERDAM, NL, Seiten 225 - 231; THERY ET AL: "LANTHANIDE ION EXCHANGE IN SODIUM BETA ALUMINOGALLATE"
- APPLIED PHYSICS A. SOLIDS AND SURFACES, Bd. A32, Nr. 3, November 1983, HEIDELBERG, DE, Seiten 159 - 161; FARRINGTON ET AL: "THE LANTHANIDE BETA DOUBLE PRIME ALUMINAS"

## Beschreibung

Die Erfindung betrifft ein verfahren zur Herstellung von Kristallen.

Natrium-β-Aluminiumoxid und Natrium-β''-Aluminiumoxid gehören zu der Familie der Natrium-Ionenleiter. Beide Phasen bestehen aus Spinell-Blöcken, die durch leitende Ebenen getrennt sind. Da sich die Stapelfolge der Spinell-Blöcke beider Phasen unterscheidet, ergeben sich unterschiedliche Anordnungen der leitenden Ebenen. Diese Unterschiede in der Kristallstruktur sowie eine unterschiedliche Charakteristik in der Ladungskompensation führen dazu, daß sich auch das Ionenaustauschverhalten der beiden Phasen unterscheidet.

Durch Austausch der Natrium-Ionen in der leitenden Ebene gegen Ionen Seltener Erden lassen sich Kristalle mit optischen Eigenschaften erzeugen, die z.B. für Linsen, Filter oder Laser Verwendung finden können. Dabei werden die optischen Eigenschaften nahezu ausschließlich durch die Art und Konzentration der Seltenen Erden vorgegeben.

Aus den Veröffentlichungen G. C. Farrington, B. Dunn, "Solid State Ionics" 7, (1982), S. 267, E. E. Hellstrom, R. E. Benner, "Solid State Ionics" 11, (1983), S. 125 und G. C. Farrington, B. Dunn, J. O. Thomas, "Appl. Phys." A 32 (1983), S 159 sind Natrium-β''-Aluminiumoxid-Kristalle bekannt, bei denen zwei- und dreiwertige Kationen in die leitende Ebene eingebaut sind. Ferner ist aus der EP-PS 0 132 321 bekannt, für optische Anwendungszwecke Kristalle auf der Basis von Natrium-β''-Aluminiumoxid zu verwenden, bei denen ein Teil der Natrium-Ionen in der leitenden Ebene durch drei- oder höherwertige Kationen ersetzt wurden.

Es hat sich aufgrund der in diesen Veröffentlichungen vorgestellten Experimente gezeigt, daß bei Na-β''-Al₂O₃ der Austauschprozeß der Ionen auch im Falle zwei- oder höherwertiger Ionen leicht durchführbar ist. Dagegen bereitet die Herstellung der Wirtskristalle selbst erhebliche Schwierigkeiten.

Das Wachsen der Kristalle verläuft nämlich sehr ungeregelt. Außerdem sind spezielle Verfahrensparameter einzuhalten, um zu vermeiden, daß bei Erstarren der Schmelze trotz richtigem Atomverhältnis Na-β-Al₂O₃ statt Na-β''-Al₂O₃ entsteht.

Andererseits bereitet die Züchtung von Na-β-Al₂O₃-Einkristallen keine Schwierigkeiten, denn hier verläuft der Kristallisationsprozeß sehr kontrolliert. Hier besteht jedoch das Problem, mehrwertige Kationen in die leitende Ebene einzubauen. Während der Austausch der Natrium-Ionen durch zweiwertige Kationen noch unter erheblichem Aufwand gelingt, waren Experimente, einen substanziellen Anteil dreiwertiger Kationen einzubauen, erfolglos. Wie die Veröffentlichung G. Aka, J. Théry, D. Vivien, "Solid State Ionics" 39 (1990), S. 225 berichtet, konnten lediglich Spuren von dreiwertigen Kationen in analogen Na-β-(Al, Ga)₂O₃-Kristallen nachgewiesen werden.

Der Erfindung liegt die Aufgabe zugrunde, ein Verfahren anzugeben, mit dem auch bei Natrium-β-Aluminiumoxid ein substantieller Austausch der Natrium-Ionen durch dreiwertige Ionen Seltener Erden ermöglicht wird.

Diese Aufgabe wird bei einem Verfahren zur Herstellung von Kristallen durch die im Anspruch 1 angegeben Merkmale gelöst.

Im Zusammenhang mit dem erfindungsgemäßen Verfahren umfaßt der Begriff Kristalle den gesamten Größenbereich von großen Einkristallen bis hin zu polykristallinem Pulver.

Ein wesentlicher Gesichtspunkt des Verfahrens besteht darin, dehydratisierte Na-β-Al₂O₃-Kristalle zu verwenden und ebenso dehydratisierte Salze Seltener Erden. Es wurde nämlich herausgefunden, daß die Ausgangsstoffe, mit denen die im obigen Stand der Technik beschrieben Experimente durchgeführt wurden, neben reinen Halogeniden Seltener Erden auch Anteile von Oxidhalogeniden aufwiesen. Es wird vermutet, daß hierin die Ursache einer erheblich eingeschränkten Beweglichkeit der Ionen der Seltenen Erden liegen könnte, die eine Ionenwanderung aus der Schmelze in den Kristall blockiert.

Durch Verwendung wasserfreier Salze Seltener Erden gelingt es in überraschender Weise, bei gleichen Austauschraten der Natrium-Ionen gegen Ionen Seltener Erden mit geringeren Prozeßtemperaturen und Prozeßzeiten im Vergleich zu bekannten Versuchsreihen mit Na-β''-Al₂O₃ auszukommen.

Die Herstellung des für die Schmelze vorgesehenen wasserfreien SE X₃ (X = Cl, Br, I) erfogt nach der Ammonium-Halogenid-Methode oder durch das Gas-Phase-Transport-Verfahren.

Diese aus den Veröffentlichungen G. Meyer, "Inorg. Synth." 25 (1989), S. 146 bzw. H. Gunsilius, W. Urland, R. Kremer "Z. anorg. allg. Chemie" 550 (1987) S. 35 an sich bekannten Verfahren ermöglichen eine sehr wirksame wasserfreie Herstellung des für die Schmelze vorgesehenen Salzes Seltener Erden, so daß ein Reinheitsgrad von 98 bis 99 % erreichbar ist. Die Entstehung von Oxiden, die die Schmelztemperatur des Salzes unerwünscht heraufsetzen würden und mutmaßlich die Beweglichkeit der Ionen Seltener Erden beeinträchtigen, wird so vermieden.

Eine Weiterbildung sieht vor, daß das Erschmelzen des SE X₃ (X = Cl, Br, I) sowie das Eintauchen der Na-β-Al₂O₃-Kristalle in die Schmelze und das Entfernen aus der Schmelze unter Schutzgas von vorzugsweise Argon durchgeführt wird.

Hierdurch gelingt es, die Reinheit des Austauschsalzes auch während des Ionen-Austausches zu gewährleisten.

Bei einer praktischen Durchführung des Verfahrens wird die Prozeßtemperatur in Abhängigkeit der Art der im Salz enthaltenen Seltenen Erden eingestellt und während der Dauer des Ionenaustausches konstantgehalten. In den häufigsten Anwendungsfällen liegt die Prozeßtemperatur im Bereich zwischen der Schmelztemperatur und ca. 850 Grad Celsius

Hierdurch werden die Voraussetzungen für einen planmäßigen Austausch der Ionen in einem Wirtskristall geschaffen, so daß Kristalle mit reproduzierbaren, gezielt einstellbaren optischen Eigenschaften erzeugt werden können. Die Prozeßtemperaturen liegen verhältnismäßig niedrig, was sich auch günstig auf die Lebensdauer eines Reaktionsgefäßes und auf die Stabilität der Kristalle selbst auswirkt.

Weiterhin wird die Prozeßzeit in Abhängigkeit der Art der im Salz enthaltenen Seltenen Erden und der angestrebten Konzentration in den leitenden Ebenen des Kristalls eingestellt. Bei Anwendung des erfindungsgemäßen Verfahrens liegt die Prozeßzeit in den meisten Anwendungsfällen in einem Bereich von 5 min bis zu 2 Tagen.

Je nach den angestrebten optischen Eigenschaften kann so ein teilweiser bis praktisch vollständiger Austausch der Natrium-Ionen gegen Ionen Seltener Erden durchgeführt werden.

Weiterhin ist vorgesehen, daß die Kristalle vorzugsweise bei nur teilweisem Austausch der Natrium-Ionen durch Ionen Seltener Erden getempert werden.

Mit diesem zusätzlichen Verfahrensschritt wird eine Homogenisierung in der Verteilung der Ionen Seltener Erden innerhalb der leitenden Ebenen erreicht. Bei den kurzen Prozeßzeiten ist nämlich zunächst die Konzentration an Ionen Seltener Erden in den äußeren Schichten des Kristalls größer als im inneren Bereich. Im inneren Bereich ist also der Anteil von Natrium-Ionen noch höher. Beim Tempern findet ein Ausgleich dieser Konzentrationsunterschiede statt, indem die Ionen Seltener Erden nach innen und im Gegenzug die Ionen von Natrium nach außen wandern, bis eine gleichmäßige Verteilung erreicht ist.

Vorzugsweise wird das Tempern bei einer Temperatur von 500 bis 700 Grad Celsius während einer Zeit von 1 bis 3 Tagen durchgeführt.

Auch diese Zeit ist wiederum davon abhängig, welche Art Ionen Seltener Erden eingebaut werden und wie hoch die Austauschrate der Natrium-Ionen gegen die Ionen Seltener Erden ist. Bei kleiner Austauschrate dauert der Prozeß entsprechend länger, während bei hoher Austauschrate von kürzeren Zeiten auszugehen ist, da sich die Natrium-Ionen dann bereits weitgehend aus der leitenden Ebene entfernt haben und eine Homogenisierung nicht mehr notwendig ist.

Schließlich betrifft die Erfindung einen Kristall.

Diesbezüglich liegt ihr die Aufgabe zugrunde, einen Kristall zu schaffen, welcher bei Ausbildung als β-Aluminium-Oxid gezielt einstellbare optische Eigenschaften besitzt.

Diese Aufgabe wird bei einem Kristall durch die im Anspruch 8 angegebenen Merkmale gelöst.

Kristalle im Sinne der Erfindung umfassen den gesamten Größenbereich von großen Einkristallen bis zu polykristallinem Pulver.

Die Ionen Seltener Erden bestimmen maßgeblich die optischen Eigenschaften des Kristalls. Durch die Konzentration, die Art der Ionen Seltener Erden sowie auch durch gleichzeitige Anordnung unterschiedlicher Ionen Seltener Erden lassen sich gezielt optische Eigenschaften wie Absorption, Fluoreszenz und Phosphoreszenz einstellen, wodurch sich leistungsfähige Anwendungen im optischen Bereich, vorzugsweise als Laser, mit genau vorhersehbaren Eigenschaften erreichen lassen.

Gemäß einer Weiterbildung können in den leitenden Ebenen auch ein- und/oder zweiwertige Ionen neben Ionen Seltener Erden vorhanden sein.

Diese Ausgestaltung schafft weitere Freiheitsgrade in der Bestimmung und Einstellung optischer Eigenschaften.

Zusätzliche Weiterbildungen und vorteilhafte Ausgestaltungen der Erfindung ergeben sich aus den Ansprüchen, der weiteren Beschreibung und der Zeichnung, anhand der die Erfindung erläutert wird.

In der Zeichnung zeigen:
- Fig. 1: eine nicht beanspruchte Vorrichtung zur Herstellung von Kristallen mit optischen Eigenschaften durch Austausch von NatriumIonen durch Ionen Seltener Erden.
- Fig. 2 bis 4: Tabellen mit Aufstellungen der Versuchsparameter verschiedener Austauschprozesse,
- Fig. 5: eine graphische Darstellung des Konzentrationsverlaufs von Natrium-Ionen und Ionen Seltener Erden über dem Querschnitt eines Kristalls.

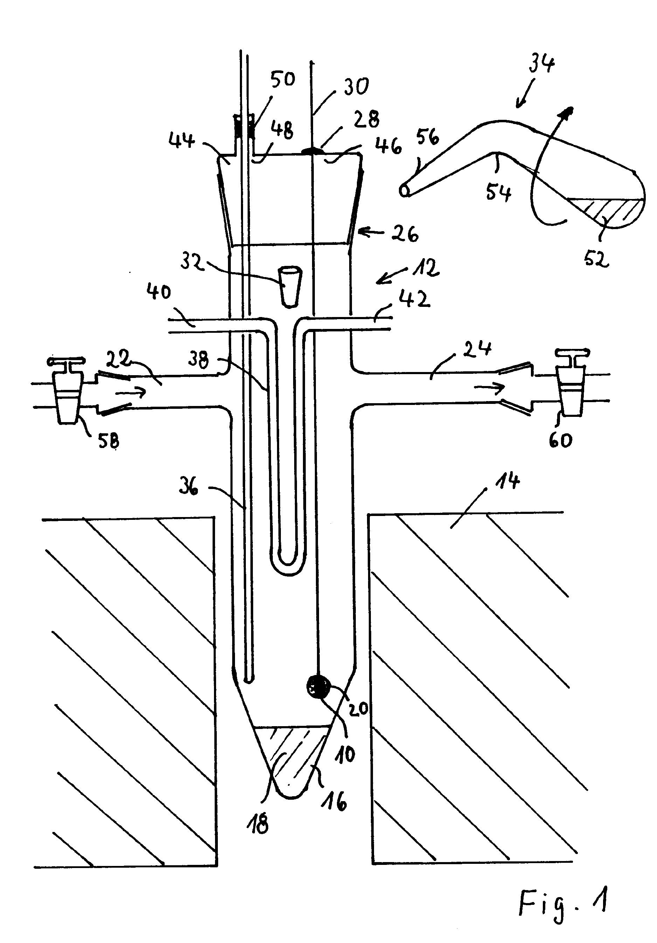

Die in Fig. 1 dargestellte nicht beanspruchte Vorrichtung umfaßt ein als Quarzrohr ausgebildetes Reaktionsgefäß 12, in derem unteren Bereich sich eine Vorratswanne 16 für die Schmelze 18 eines Austauschsalzes befindet. Die Vorratswanne 16 verjüngt sich nach unten hin kegelförmig.

Mit seinem unteren Bereich taucht das Reaktionsgefäß 12 in einen Ofen 14 ein, so daß gewährleistet ist, daß die Vorratswanne 16 einer gleichmäßigen Erwärmung ausgesetzt ist. Im mittleren Bereich außerhalb des Ofens 14 sind Ein- 22 und Auslässe 24 zur Evakuierung sowie zur Einleitung von Schutzgas wie Stickstoff oder Argon vorgesehen, das durch den Einlaß 22 ein- und durch den Auslaß 24 wieder austreten kann. Der Ein- 22 und Auslaß 24 läßt sich durch jeweils ein Ventil 58, 60 absperren. Außerdem ist im mittleren und oberen Bereich des Reaktionsgefäßes 12 eine Kühlschlange 38 angeordnet, welche mit einem Ein-40 und Auslaß 42 für Kühlmittel versehen ist.

Eine Verschlußwand 26 an der Stirnseite des Reaktionsgefäßes 12 ist durch einen Stopfen 44 mit einem konischen Außenschliff gebildet, der in einer ebenfalls konischen Öffnung des Reaktionsgefäßes 12 ruht und den Innenraum gegen die Außenatmosphäre dicht verschließt.

Der Stopfen besitzt 44 zwei Öffnungen 46, 48. Durch die eine Öffnung 46 führt ein Draht 30 aus Platin, der an seinem unteren Ende ein ebenfalls aus Platin bestehendes Netz 20 zur Aufnahme eines zu behandelnden Kristalls 10 trägt. Durch die andere Öffnung 48 führt ein Temperaturfühler 36, der etwa bis in den Bereich der Vorratswanne 16 ragt.

Die vom Draht 30 durchgriffene Öffnung 46 umfaßt eine thermoelastische Dichtung 28. Wird die Dichtung 28 erwärmt, so kann der Draht 30 auf und ab bewegt werden. Befindet sich die Dichtung 28 jedoch im kalten Zustand, so wird der Draht 30 fixiert.

Der die andere Öffnung 48 durchgreifende Temperaturfühler 36 ist gegen die Öffnung 48 durch eine Quetschdichtung 50 abgedichtet.

Außerdem ist eine Füllöffnung 32 mit einem Kegelschliff vorhanden, an die eine Füllbirne 34 mit Austauschsalz angesetzt werden kann. Diese Füllbirne 34 besteht aus einem Vorratsbehälter 52, der über ein abgewinkeltes Knie 54 zu einem Füllstutzen 56 führt. Der Füllstutzen 56 weist ebenfalls einen Kegelschliff auf und paßt abdichtend in die Füllöffnung 32 des Reaktionsgefäßes 12.

Zur Durchführung des Herstellungsprozesses wird wie folgt vorgegangen:

Zunächst wird wasserfreies Austauschsalz gewonnen. Dies kann durch eine an sich bekannte Methode, z. B. durch die Ammonium-Halogenid-Methode oder durch das Gas-Phase-Transport-Verfahren erzeugt werden. Bei der Ammonium-Halogenid-Methode wird so vorgegangen, daß über einen Komplex aus Ammonium, Seltenen Erden und Halogen Halogenwasserstoff geleitet wird, während der Komplex erwärmt wird. Dabei entweicht Wasserdampf. Anschließend wird der zurückbleibende Komplex zersetzt, wobei Ammoniumhalogenid entweicht und ein Seltenerdhalogenid der allgemeinen Formel SE X₃ (X = Cl, Br, I) als Pulver zurückbleibt. Dieses pulverförmige SE X₃ (X = Cl, Br, I) wird in die Füllbirne 34 gefüllt.

Nachdem die Füllbirne 34 mit ihrem Füllstutzen 56 auf die Füllöffnung 32 gesetzt und ein oder mehrere zu behandelnde Kristalle 10 in Netzen 20 in das Reaktionsgefäß 12 gehängt wurden, wird dieses evakuiert, indem das Ventil 60 geschlossen und der Einlaß 22 bei geöffnetem Ventil 58 mit einer hier nicht dargestellten Vakuumpumpe verbunden wird. Nun wird der Ofen 14 geheizt und die im Reaktionsgefäß 12 befindlichen Kristalle 10 bei ca. 500 Grad Celsius mehrere Stunden dehydratisiert.

Zur Durchführung des anschließenden Ionenaustausches wird die Temperatur gesteigert, bis die Prozeßtemperatur erreicht ist, wobei die Kontrolle und Regelung der Temperatur mit Hilfe des Temperaturfühlers 36 erfolgt. Sobald die Prozeßtemperatur erreicht ist, wird das Reaktionsgefäß 12 mit Argon gespült und die im Reaktionsgefäß 12 noch befindliche Restluft auf diese Weise verdrängt.

Nach Erreichen einer ausreichend reinen Schutzgasatmosphäre wird die Füllbirne 34 so verdreht, daß der anfangs unten liegende Vorratsbehälter 52 nach oben überführt wird und das pulverförmige Austauschsalz durch den Füllstutzen 56 in das Reaktionsgefäß 12 rutscht und sich dort in der Vorratswanne 16 sammelt.

Das Austauschsalz beginnt nun zu schmelzen und wenn die Schmelztemperatur überschritten und die Prozeßtemperatur erreicht ist, wird ein zuvor im Netz 20 plazierter Kristall an seinem Draht 30 von oben in die Schmelze 18 gesenkt. Zu diesem Zweck wird die thermoplastische Dichtung 28, durch die der Draht 30 führt, erwärmt, wodurch sie weich wird und der Draht 30 nun ungehindert längs verschoben werden kann. Nach Abkühlen der Dichtung 28 verharrt der Draht 30 in seiner derzeitigen Position und hält das Netz 20 auf dem entsprechenden Höhenniveau fest.

Während der Kristall 10 nun in die Schmelze 18 eintaucht, findet ein Austausch der Natrium-Ionen in der leitenden Ebene gegen die Ionen Seltener Erden des Austauschsalzes statt. Dabei gelangen die Ionen der Seltenen Erden in die Ebenen, in denen vorher Natrium-Ionen lagerten, während die Natrium-Ionen in die Schmelze gelangen und mit den frei gewordenen Halogenid-Ionen Natrium-Halogenid bilden.

Im Verhältnis zur auszutauschenden Menge von Natrium-Ionen wird in der Schmelze mit einem Überschuß von SE X₃ (X = Cl, Br, I) gearbeitet, so daß praktisch keine Konzentrationsänderung im Laufe des Prozess stattfindet.

Eine gesteigerte Mobilität der Ionen kann dadurch erreicht werden, daß das Netz 20 am Draht 30 auf und ab bewegt und dadurch die Konzentration von Ionen Seltener Erden an der Oberfläche des Kristalls 10 erhöht, während gleichzeitig die Konzentration der Natrium-Ionen verringert wird.

Die Schmelze kann sowohl aus dem Salz nur einer einzigen Verbindung Seltener Erden bestehen oder auch aus einem Gemenge in unterschiedlichen Konzentrationen. In Abhängigkeit der verwendeten Seltene Erden wird die Reaktionstemperatur und Prozeßzeit unterschiedlich bemessen. Nachdem sich die auf Grund von Vorversuchen ermittelte gewünschte Konzentration über den Austausch von Natrium-Ionen durch Ionen Seltener Erden eingestellt hat, kann der Kristall 10 aus der Schmelze 18 entnommen, gespült und weiterverarbeitet werden.

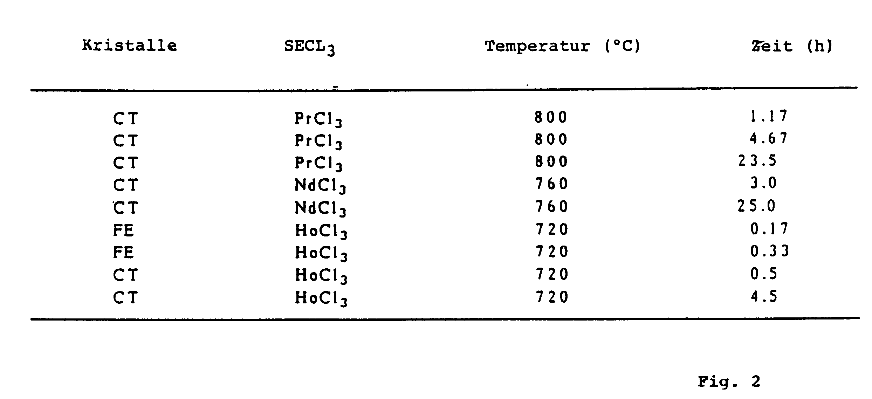

Die Fig. 2 bis 4 zeigen Tabellen mit Aufstellungen der Versuchsparameter verschiedener Austauschprozesse. Die Tabelle in Fig. 2 gibt experimentelle Bedingungen für den Natrium-Austausch in Na-β-Al₂O₃ an. Die Kristalle sind benannt als FE und CT. FE ist ein Nebenprodukt von Kristallzüchtungen durch Flußmittelverdampfung. CT sind Kristalle, die von Ceramatech Inc. bezogen wurden.

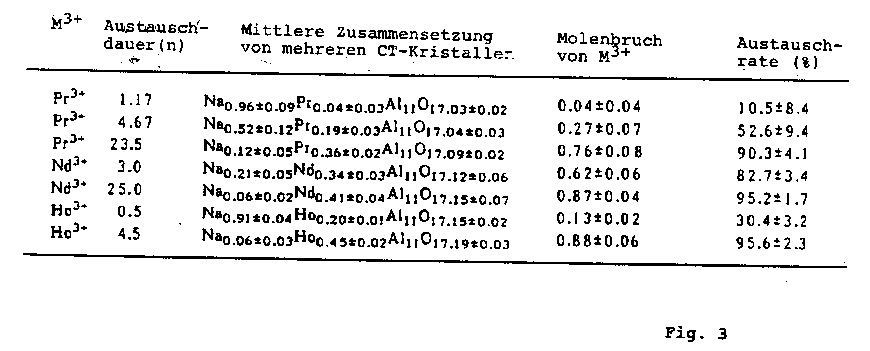

Die Tabelle in Fig. 3 zeigt die Zusammensetzung von Na-β-Al₂O₃-Kristallen nach einem M³⁺-Ionenaustausch (M³⁺ = Pr³⁺, Nd³⁺, Ho³⁺). Man erkennt, daß die Austauschraten bei gleichen Prozeßzeiten sehr stark von der Art der Seltenen Erden abhängen. Dennoch sind, selbst im Vergleich mit Na-β''-Aluminiumoxid, relativ geringe Prozeßzeiten erforderlich, um hohe Austauschraten zu erzielen.

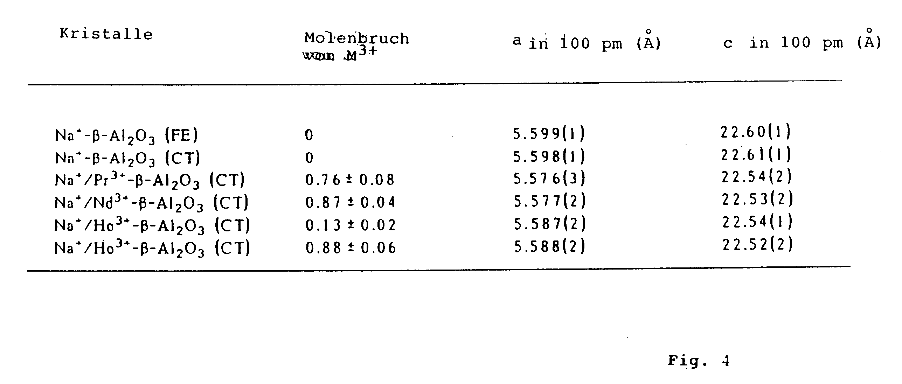

Die Tabelle in Fig. 4 zeigt Gitterkonstanten von Na-β-Al₂O₃ und teilweise ausgetauschten Na⁺/M³⁺-β-Al₂O₃-Kristallen (M³⁺ = Pr³⁺, Nd³⁺, Ho³⁺).

Für den Fall, daß nur ein prozentual geringer Ionenaustausch beabsichtigt wurde und stattgefunden hat, kann in einem anschließendem Temper-Prozeß die Homogenität der Verteilung der Ionen Seltener Erden in den leitenden Ebenen des Kristalls verbessert werden.

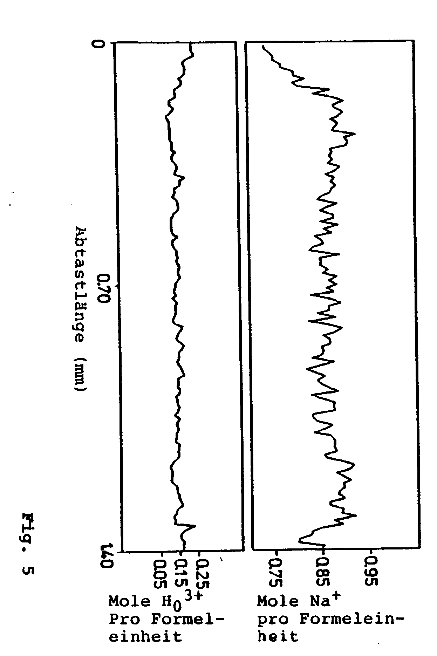

Fig. 5 zeigt eine graphische Darstellung des Konzentrationsverlaufs von Natrium-Ionen und Ionen Seltener Erden, hier Holmium-Ionen, in einem ungetemperten Einkristall der Zusammensetzung: Na_{0,88} Ho_{0,14} Al₁₁ O_{17,15}. Die experimentellen Bedingungen waren: 0,5 h in HoCl₃ bei 720 Grad Celsius. Der Konzentrationsverlauf ist über dem Querschnitt eines Kristalls nach Beendigung des Ionenaustauschprozesses aufgetragen. Wird ein solcher Kristall noch getempert, so würde die Messung der Konzentration einen nahezu geradlinigen Verlauf ergeben.

## Patentansprüche

1. Verfahren zur Herstellung von Kristallen, welche ein Wirtsgitter aus β-Aluminium-Oxid und in leitenden Ebenen wenigstens einen Anteil an dreiwertigen Ionen Seltener Erden umfassen, bei dem dehydratisierte Na-β-Al₂O₃-Kristalle in eine reine durch einen vorgeschalteten Prozeß nach der Ammonium-Halogenid-Methode oder durch das Gas-Phase-Transport-Verfahren bereitgestellte SE X₃-Schmelze (X = Cl, Br, I) eingetaucht werden, dort unter einer in Vorversuchen für eine gewünschte Konzentration Ionen Seltener Erden ermittelter Prozeßtemperatur und Prozeßzeit belassen und anschließend wieder aus der Schmelze entfernt werden.

2. Verfahren nach Anspruch 1, dadurch gekennzeichnet, daß das Erschmelzen des SE X₃ (X = Cl, Br, I) sowie das Eintauchen der Na-β-Al₂O₃-Kristalle in die Schmelze und das Entfernen aus der Schmelze unter Schutzgas von vorzugsweise Argon durchgeführt wird.

3. Verfahren nach Anspruch 1 oder 2, dadurch gekennzeichnet, daß die Prozeßtemperatur in Abhängigkeit der Art der im Salz enthaltenen Seltenen Erden eingestellt und während der Dauer des Ionenaustausches konstantgehalten wird.

4. Verfahren nach einem oder mehreren der Ansprüche 1 bis 3, dadurch gekennzeichnet , daß die Prozeßtemperatur im Bereich zwischen der Schmelztemperatur und ca. 850 Grad Celsius liegt.

5. Verfahren nach einem oder mehreren der Ansprüche 1 bis 4, dadurch gekennzeichnet , daß die Prozeßzeit in einem Bereich von 5 min bis zu 2 Tagen liegt.

6. Verfahren nach einem oder mehreren der Ansprüche 1 bis 5, dadurch gekennzeichnet , daß die Kristalle, vorzugsweise nach nur teilweisem Austausch der Natrium-Ionen durch Ionen Seltener Erden, getempert werden.

7. Verfahren nach Anspruch 6, dadurch gekennzeichnet, daß das Tempern bei einer Temperatur von 500 bis 700 Grad Celsius während einer Zeit von 1 bis 3 Tagen durchgeführt wird.

8. Kristall, welcher ein Wirtsgitter aus β-Aluminium-Oxid und in leitenden Ebenen einen Anteil zwischen 2 und 95 % der in den leitenden Ebenen vorhandenen Ionen an dreiwertigen Ionen Seltener Erden umfaßt.

9. Kristall nach Anspruch 8, dadurch gekennzeichnet, daß in den leitenden Ebenen auch ein- und/oder zweiwertige Ionen neben Ionen Seltener Erden vorhanden sind.

10. Kristall nach Anspruch 8 oder 9, dadurch gekennzeichnet, daß bei einem Na-β-Al₂O₃ mit Na₁₊ₓ Al₁₁ O_{17+x/2′} wobei x = ca. 0,2 bis 0,3 ein Teil der Natrium-Ionen durch Ionen Seltener Erden aus einem Seltenerdhalogenid SE X₃ (X = Cl, Br, I) ausgetauscht ist, so daß Na_{1+x-3z} SE_{z}Al₁₁ O_{17+x/2} entsteht.

## Claims

1. Method of making crystals, which comprise a host lattice of β-aluminium oxide and, in conducting planes, at least a proportion of trivalent ions of rare earths, in which dehydrated Na-β-Al₂O_{3L} crystals are dipped into a pure rare earth-X₃ melt (where X = Cl, Br, I), already prepared by a prior process by the ammonium halide method or by the gaseous phase transport method, are left there at a process temperature and for a process time determined in prior tests for a desired concentration of ions of rare earths, and are then again removed from the melt.

2. Method according to Claim 1, characterized in that the melting of the rare earth-X₃ (X = Cl, Br, I) and the dipping of the Na-β-Al₂O₃ crystals into the melt and the removal from the melt are carried out under a protective gas of preferably argon.

3. Method according to Claim 1 or 2, characterized in that the process temperature is set as a function of the type of rare earths contained in the salt and is maintained constant throughout the duration of the ion exchange.

4. Method according to one or more of Claims 1 to 3, characterized in that the process temperature lies in the range between the fusion temperature and approx. 850°C.

5. Method according to one or more of Claims 1 to 4, characterized in that the process time lies in the range of 5 minutes to 2 days.

6. Method according to one or more of Claims 1 to 5, characterized in that the crystals are tempered, preferably after only partial replacement of the sodium ions by ions of rare earths.

7. Method according to Claim 6, characterized in that the tempering is carried out at a temperature of 500 to 700°C for a period of 1 to 3 days.

8. Crystal, which comprises a host lattice of β-aluminium oxide and, in conducting planes, a proportion of between 2 and 95% of trivalent ions of rare earths in the ions present in the conducting planes.

9. Crystal according to Claim 8, characterized in that monovalent and/or bivalent ions are present, in addition to ions of rare earths, in the conducting planes.

10. Crystal according to Claim 8 or 9, characterized in that, in the case of an Na-β-Al₂O₃ with Na₁₊ₓ Al₁₁ O₁₇₊_{x/2}, where x = approx. 0.2 to 0.3, a portion of the sodium ions is replaced by ions of rare earths of a rare earth halide (rare earth-X₃, where X = Cl, Br, I), so that Na_{1+x-3z} rare earth_{z} Al₁₁ O_{17+x/2} is produced.

## Revendications

1. Procédé de production de cristaux, qui comprennent un réseau d'hôte d'oxyde d'aluminium β et, dans des plans conducteurs, au moins une partie d'ions trivalents de terres rares, dans lequel des cristaux de Na-β-Al₂O₃ déshydratés sont plongés dans un bain fondu de SE X3 (X = Cl, Br, I) pur, préparé par un procédé amont selon la méthode halogénure d'ammonium ou par le procédé de transport de phase de gaz, sont laissés à une température donnée et pendant un temps approprié pour une concentration désirée d'ions de terres rares et, enfin, sont retirés de la masse fondue.

2. Procédé suivant la revendication 1, caractérisé en ce que la fonte de SE X3 (X = Cl, Br, I) ainsi que l'immersion du cristal Na-β-Al₂O₃ dans le bain fondu et le retrait du bain fondu sont exécutés sous gaz protecteur, de préférence de l'argon.

3. Procédé suivant la revendication 1 ou 2, caractérisé en ce que la température du procédé est établie suivant le type des terres rares contenues dans le sel et maintenue constante pendant la durée de l'échange d'ions.

4. Procédé suivant une ou plusieurs des revendications 1 à 3, caractérisé en ce que la température du procédé se trouve dans la plage comprise entre la température de fusion et 850° C environ.

5. Procédé suivant une ou plusieurs des revendications 1 à 4, caractérisé en ce que la durée du procédé se trouve dans une plage de 5 mn à 2 jours.

6. Procédé suivant une ou plusieurs des revendications 1 à 5, caractérisé en ce que les cristaux, de préférence après seulement échange partiel des ions sodium par des ions de terres rares, sont recuits.

7. Procédé suivant la revendication 6, caractérisé en ce que le recuit est réalisé à une température de 500° C à 700° C pendant une durée de 1 à 3 jours.

8. Cristal qui comprend un réseau d'hôte en oxyde d'aluminium β et dans des plans conducteurs, une partie comprise entre 2 et 95 % d'ions présents dans les plans conducteurs sur des ions trivalent de terres rares.

9. Cristal suivant la revendication 8, caractérisé en ce que, dans les plans conducteurs, sont présents aussi des ions monovalents et/ou bivalents auprès des ions de terres rares.

10. Cristal suivant la revendication 8 ou 9, caractérisé en ce que, dans un Na-β-Al₂O₃ comportant Na₁₊ₓ O_{17+x/2} où x = 0,2 à 0,3 environ, une partie des ions sodium est échangé par des ions de terres rares provenant d'halogénure de terre rare SE X3 (X = Cl, Br, I), de manière à avoir Na_{1+x-3z} SE_{z} Al₁₁ O_{17+x/2}
